# EUROPÄISCHE PATENTSCHRIFT

(11) **EP 1 275 562 B1**
(45) Veröffentlichungstag und Bekanntmachung des Hinweises auf die Patenterteilung: **31.05.2006**
(21) Anmeldenummer: 02015242.7
(22) Anmeldetag: 09.07.2002
(51) Int. Cl.: B60R 11/02, H04B 1/06, H03J 7/18, H04H 1/00

(54) **Anordnung für einen Motor aufweisendes Kraftfahrzeug mit Funksignalempfänger**
Arrangement for a motor vehicle with a radio receiver
Aménagement pour véhicule à moteur avec récepteur radio

(30) Priorität: 10.07.2001 DE 10133481
(43) Veröffentlichungstag der Anmeldung: 15.01.2003
(73) Patentinhaber: Harman/Becker Automotive Systems (Becker Division) GmbH, 76307 Karlsbad (DE)
(72) Erfinder: Benz, Christoph, 77797 Ohlsbach (DE); Gierl, Stefan, 76133 Karlsruhe (DE); Körner, Andreas, 76307 Karlsbad (DE)
(74) Vertreter: Patentanwälte Westphal, Mussgnug & Partner

(56) Entgegenhaltungen:
- EP-A- 0 459 360
- EP-A- 0 921 637
- DE-A- 3 511 213
- DE-A- 19 749 536
- US-A- 4 218 717

## Beschreibung

Die vorliegende Erfindung betrifft eine Anordnung mit einem Empfänger für Funksignale, der auf eine Mehrzahl unterschiedlicher Empfangsfrequenzen abstimmbar ist und eingerichtet ist, in einem Arbeitsbetriebszustand ein aus einem bei einer eingestellten Frequenz empfangenes Funksignal gewonnenes Signal an eine Wiedergabeeinheit auszugeben und in einem Bereitschaftsbetriebszustand Informationen wenigstens über die Identität eines bei einer gegebenen Frequenz empfangbaren Senders zu erfassen und in einem Speicher aufzuzeichnen. Zweck dieses Sammelns von Informationen ist, unter mehreren Frequenzen, bei denen ein gleicher Sender in einem Frequenzband empfangbar ist, stets automatisch diejenige auswählen und im Betriebszustand einstellen zu können, die den besten Empfang ermöglicht, wobei der Empfänger eingerichtet ist, bei Inbetriebnahme zunächst im Bereitschaftsbetriebszustand Information über eine Mehrzahl von Sendern zu erfassen und aufzuzeichnen, bevor er in den Arbeitsbetriebszustand wechselt, wobei die Steuereinheit an wenigstens einen Sensor gekoppelt ist und eingerichtet ist, den Empfänger je nach Erfassungsergebnis des wenigstens einen Sensors in und/oder außer Betrieb zu nehmen und wobei einer der Sensoren ein Sensor zum Erfassen der Annäherung eines Benutzers ist, und die Steuereinheit den Empfänger automatisch in Betrieb nimmt, wenn die Annäherung eines Benutzers erfasst wird.

Rundfunkempfänger mit dieser Fähigkeit sind beispielsweise aus der EP 0 921 637 bekannt. Die Verwendung von Türzustandssignalen zur Aktivierung unterschiedlicher Funktion am Kraftfahrzeug ist beispielsweise aus der DE 197 49 536 A1 bekannt.

Um immer unter mehreren zur Auswahl stehenden Sendern denjenigen mit der besten Empfangsqualität einstellen zu können, ist es von Vorteil, wenn der Funkempfänger so viele Informationen wie möglich über das gesamte Empfangsband zur Verfügung hat. Bei herkömmlichen Autobest-Empfängern wird zu diesem Zweck der Betrieb im Arbeitsbetriebszustand von Zeit zu Zeit unterbrochen, um im Bereitschaftsbetriebszustand jeweils an einer anderen Frequenz des Empfangsbandes zu überprüfen, ob und mit welcher Qualität ein Sender bei dieser Frequenz empfangbar ist und welches seine Identität ist. Die Durchmusterung des gesamten FM-Frequenzbandes zu diesem Zweck nimmt eine Zeitspanne von einigen Sekunden in Anspruch. Eine so lange Unterbrechung der Audiosignalausgabe würde von einem Zuhörer als störend empfunden. Daher wechselt der herkömmliche Autobest-Empfänger nur von Zeit zu Zeit aus dem Arbeitsbetriebszustand in den Bereitschaftsbetriebszustand, um dort für eine einzelne Frequenz zu überprüfen, ob und mit welcher Qualität ein Sender bei dieser Frequenz empfangbar ist und welches seine Identität ist, und diese Information aufzuzeichnen. Es liegt auf der Hand, dass auf diese Weise eine Durchmusterung des gesamten Empfangsbandes viele Minuten in Anspruch nehmen kann.

Um dennoch auch nach einem Einschalten des Empfängers die Autobest-Funktionalität schnell zur Verfügung zu haben, ist es bekannt, die über das Frequenzband und die darin empfangbaren Sender gesammelten Informationen in einem Speicher aufzuzeichnen, der auch beim Ausschalten des Empfängers seinen Inhalt beibehält, so dass die darin gespeicherten Informationen beim Wiedereinschalten des Empfängers sofort zur Verfügung stehen.

Diese Lösung ist aus mehreren Gründen nicht vollauf befriedigend. Zum einen sind derartige Speicher teuer, weswegen häufig nicht die Speicherkapazität vorgesehen wird, die notwendig wäre, um Informationen zu allen in dem Frequenzband empfangbaren Sendern zu speichern, sondern es wird lediglich Information zu dem jeweils zuletzt gehörten Sender gespeichert. Dies hat zur Folge, dass wenn ein Benutzer kurz nach dem Einschalten des Empfängers einen neuen Sender einstellt, die Gefahr groß ist, dass Informationen zu Ausweichfrequenzen für diesen Sender nicht gespeichert sind, so dass diese Informationen erst neu gesammelt werden müssen. Da der Empfänger nicht vorab "weiß", wo Ausweichfrequenzen für einen eingestellten Sender zu finden sein könnten, muss er hierfür das gesamte Empfangsband durchmustern, mit der Folge, dass die Senderoptimierung träge reagiert, genau so, als wenn überhaupt keine Senderinformation während des Ausschaltens gespeichert geblieben wäre.

Zwar ließe sich dieser Nachteil durch großzügigen Einsatz von nichtflüchtigem Speicherplatz für die Senderinformationen beheben, ein anderer mit dieser Vorgehensweise verknüpfter Nachteil jedoch nicht. Wenn nämlich der Empfänger an einem ersten Ort ausgeschaltet wird, dann bewegt wird und an einem zweiten Ort wieder eingeschaltet wird, so entspricht zum Zeitpunkt des Wiedereinschaltens die gespeicherte Senderinformation der Senderlandschaft am ersten Ort, die von der am zweiten Ort völlig verschieden sein kann. Auch in diesem Fall muss nach dem Einschalten des Empfängers die gesamte Senderinformation erst neu gesammelt werden, bevor eine Empfangsoptimierung möglich ist.

Aufgabe der vorliegenden Erfindung ist, eine Anordnung mit einem Empfänger der eingangs genannten Art und einer Steuereinheit dafür anzugeben, die eine effiziente Empfangsoptimierung bereits unmittelbar nach Eingabe eines Einschaltbefehls für den Empfänger durch einen Benutzer oder zumindest mit einer verringerten Verzögerung ab Eingabe dieses Befehls ermöglichen.

Die Aufgabe wird durch eine Anordnung gemäß Patentanspruch 1 gelöst, wobei die Steuereinheit zudem einen Sensor zum Erfassen des Einschaltens des Motors des Kraftfahrzeugs umfasst und dass die Steuereinheit den Empfänger außer Betrieb nimmt, wenn in einer vorgegebenen Zeitspanne nach dem Erfassen der Annäherung dieser Sensor anzeigt, dass der Motor des Fahrzeugs nicht eingeschaltet ist. Ausgestaltungen und Weiterbildungen des Erfindungsgedankens sind Gegenstand von Unteransprüchen.

Ein Vorteil der Anordnung gemäß der Erfindung ist, dass sie keine permanenten Speicher erfordern.

Ein Aspekt der Lösung der Aufgabe ist ein Empfänger für Funksignale vom eingangs genannten Typ, der eingerichtet ist, bei Inbetriebnahme zunächst im Bereitschaftsbetriebszustand Informationen über eine Mehrzahl von Sendern zu erfassen und aufzuzeichnen, bevor er in den Arbeitsbetriebszustand wechselt. Dies bedeutet zwar, dass der Empfänger unmittelbar nach Inbetriebnahme noch kein Ausgangssignal an eine Wiedergabeeinheit zur Ausgabe als Audiosignal liefern kann, doch muss dies bei Verwendung des Empfängers in einer geeigneten Anordnung keineswegs eine Minderung des Hörkomforts für einen Benutzer bedeuten, wie im folgenden noch deutlich wird.

Einer bevorzugten Ausgestaltung zufolge verfügt der Empfänger über eine Einrichtung zum Empfangen eines Schaltbefehls von einem Benutzer und ist eingerichtet, um bei Empfang des Schaltbefehls vom Bereitschafts- in den Arbeitsbetriebszustand zu wechseln. D.h. die Inbetriebnahme des Empfängers kann vor der Eingabe des Schaltbefehls durch den Benutzer und unabhängig von dieser erfolgen. Wenn erstere rechtzeitig vor der Eingabe des Schaltbefehls erfolgt ist, ist das Sammeln der Senderinformation durch den Empfänger bereits abgeschlossen, bevor der Benutzer den Schaltbefehl eingibt, weil er ein Audiosignal hören möchte.

D.h. wenn der Benutzer z.B. durch Betätigen einer Taste, die für ihn wie ein Ein-Aus-Schalter des Empfängers erscheinen mag, den Schaltbefehl eingibt, so führt dies nicht zur Inbetriebnahme des Empfängers - diese hat schon vorher stattgefunden -, sondern lediglich zu einem Übergang des Empfängers vom Bereitschafts- in den Arbeitsbetriebszustand. Eine nochmalige Betätigung der gleichen Taste kann zur Rückkehr in den Bereitschaftsbetriebszustand führen.

Einem zweiten Aspekt der Erfindung zufolge ist der oben definierte Empfänger Teil einer Anordnung zusammen mit einer Steuereinheit, die an wenigstens einen Sensor gekoppelt ist und eingerichtet ist, den Empfänger je nach Erfassungsergebnis des wenigstens einen Sensors in und/oder außer Betrieb zu nehmen. Ein solcher Sensor kann zum Erfassen eines beliebigen Parameters vorgesehen werden, der auf eine erhöhte Wahrscheinlichkeit hinweist, dass ein Benutzer versuchen wird, den Schaltbefehl einzugeben. Ein solcher Sensor kann z.B. zum Erfassen der Annäherung eines Benutzers dienen, wobei die Steuereinheit den Empfänger automatisch in Betrieb nimmt, wenn die Annäherung eines Benutzers erfasst wird.

Bei der in ein Kraftfahrzeug eingebauten Anordnung aus Empfänger und Steuereinheit kann der Detektor z.B. an den Zustand eines Türschlosses des Kraftfahrzeuges gekoppelt sein und die Annäherung eines Benutzers am Öffnen des Türschlosses erfassen. D.h. wenn der Benutzer die Fahrzeugtür aufsperrt, so nimmt die Steuereinheit automatisch den Empfänger in Betrieb, und dieser beginnt, in seinem Bereitschaftsbetriebszustand das Empfangsfrequenzband zu durchmustern. Erst wenn der Benutzer im Fahrzeug Platz genommen hat, ist damit zu rechnen, dass er den Schaltbefehl eingeben wird, zu diesem Zeitpunkt kann die Durchmusterung aber bereits abgeschlossen sein.

Die Verwendung eines an den Zustand des Türschlosses gekoppelten Sensors ist zwar besonders vorteilhaft, weil sie die Erfassung der Annäherung eines Benutzers in einem frühen Stadium zu erfassen erlaubt; denkbar und mit von der Erfindung erfasst ist aber auch die Verwendung diverser anderer Sensortypen, z.B. eines an den Gurtschließer gekoppelten Sensors zum Erfassen des Schließens des Sicherheitsgurts durch einen Benutzer; eines am Fahrersitz installierten Gewichtssensors zum Erfassen einer auf dem Fahrersitz Platz nehmenden Person etc..

Da das Aufsperren der Tür nicht notwendigerweise bedeutet, dass tatsächlich eine Person im Fahrzeug Platz nehmen und den Empfänger einschalten wird, ist es zweckmäßig, noch einen zweiten Sensor zum Erfassen des Einschaltens des Motors des Kraftfahrzeugs vorzusehen, der es der Steuereinheit ermöglicht, den Empfänger wieder außer Betrieb zu nehmen, wenn in einer vorgegebenen Zeitspanne nach dem Erfassen der Annäherung der zweite Sensor anzeigt, dass der Motor des Fahrzeugs nicht eingeschaltet ist.

An die oben bereits erwähnte Wiedergabeeinheit können neben dem Empfänger auch andere Signalquellen wie etwa ein CD Spieler, ein Kassettenrecorder oder auch eine Freisprechanlage eines Autotelefons angeschlossen sein. Wenn die Wiedergabeeinheit von einer dieser Quellen Signale empfängt, ist es nicht erforderlich, dass der Empfänger im Arbeitsbetriebszustand bleibt. Um jedoch die gesammelte Senderinformation aktuell zu halten, wird der Empfänger in einem solchen Fall nicht von der Steuereinheit außer Betrieb genommen, sondern er nimmt den Bereitschaftsbetriebszustand ein, um Senderinformationen zu erfassen und aufzuzeichnen. Dabei muss die Durchmusterung des Frequenzbandes natürlich nicht ständig erfolgen, sondern es genügt, sie in zwei Abständen von einigen Minuten zu wiederholen.

Die Komponenten der Anordnung für die Steuereinheit und der Empfänger können über ein Netzwerk, z.B. in einem MOST-Netzwerk verbunden sein. Bei der Inbetriebnahme eines solchen Netzwerks kann eine Initialisierung erforderlich sein, die mehrere Sekunden in Anspruch nehmen kann und vor deren Ablauf die volle Übertragungsfähigkeit des Netzwerks, die insbesondere zum Übertragen des Ausgangssignals des Empfängers an die Wiedergabeeinheit erforderlich ist, nicht zur Verfügung steht. Wenn die Inbetriebnahme des Empfängers an die des Netzwerks gekoppelt ist, kann auch diese Zeitspanne genutzt werden, um darin die Durchmusterung des Frequenzbandes durchzuführen, so dass die benötigten Senderinformationen bereitstehen, sobald das Netzwerk vollständig initialisiert ist.

Weitere Merkmale und Vorteile der Erfindung ergeben sich aus der nachfolgenden Beschreibung von Ausführungsbeispielen mit Bezug auf die beigefügten Figuren. Es zeigen:
- Fig. 1: ein Blockdiagramm eines MOST-Netzwerks als Beispiel einer Anordnung mit einem Empfänger und einer Steuereinheit gemäß der Erfindung und
- Fig. 2: ein Flussdiagramm eines von der Steuereinheit und dem Empfänger durchgeführten Arbeitsverfahrens.

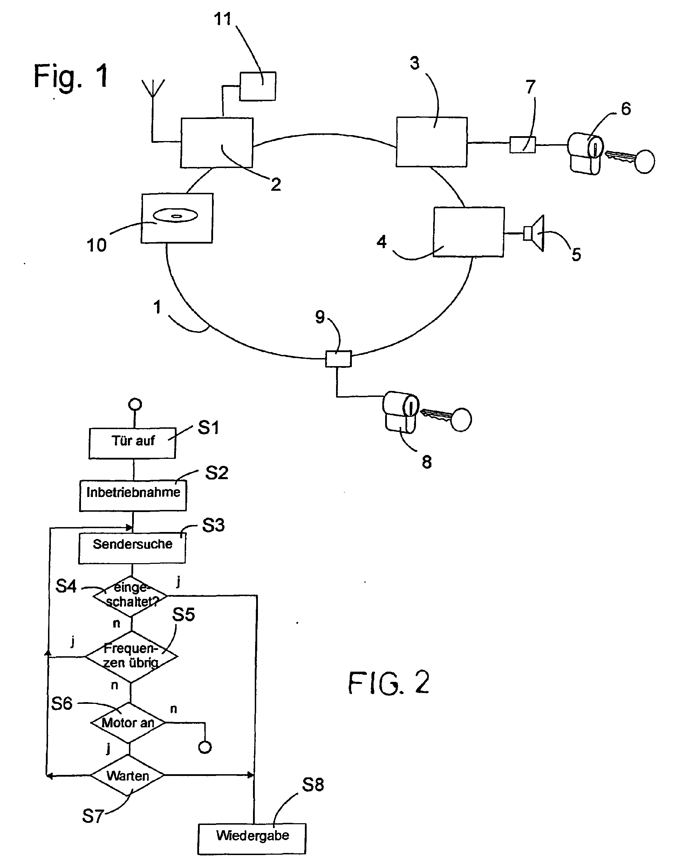

Fig. 1 zeigt ein Blockdiagramm eines MOST-Netzwerks mit einer Mehrzahl von über eine Ringleitung 1 verbundenen Einheiten. Zu diesen Einheiten gehört ein Funkempfänger 2, eine Steuereinheit 3, die gleichzeitig mit Bedienungselementen ausgestattet ist und somit als Schnittstelle zu einem Benutzer dient; eine Wiedergabeeinheit 4, die über die Ringleitung ein Ausgangssignal des Funkempfängers 2 empfängt und als Audiosignal über einen Lautsprecher 5 ausgibt; einen an ein Türschloss 6 gekoppelten ersten Sensor in Form eines mit der Steuereinheit 3 direkt verbundenen Schalters 7, einen an ein Zündschloss 8 gekoppelten zweiten Sensor in Form eines mit der Steuereinheit 3 über die Ringleitung kommunizierenden Schalters 9 sowie ein CD-Abspielgerät 10.

Die gesamte Anordnung ist in einem Kraftfahrzeug eingebaut. Der Rundfunkempfänger 2 umfasst einen flüchtigen Speicher 11, der vorgesehen ist, um Senderinformationen aufzunehmen.

Wenn das Fahrzeug abgestellt ist, sind der Funkempfänger 2, die Steuereinheit 3 und die Wiedergabeeinheit 4 stromlos, und der Speicher 11 enthält keine Daten.

Wenn ein Benutzer das Türschloss 6 aufsperrt, schließt der Schalter 7, und die Steuereinheit 3 wird mit Strom versorgt (Schritt S1 in Fig. 2). Diese nimmt daraufhin den Funkempfänger 2 durch Einschalten von dessen Stromversorgung in Betrieb (S2). Der Funkempfänger geht zunächst in den Bereitschaftsbetriebszustand der Sendersuche S3 über, in dem er sich zunächst auf eine vorgegebene Startfrequenz abstimmt und überprüft, ob ein Sender an dieser Frequenz empfangbar ist, welches gegebenenfalls die durch den PI-Code repräsentierte Identität des Senders ist und welches seine Empfangsfeldstärke ist. Wenn ein Sender empfangbar ist, werden die entsprechenden Parameter in dem Speicher 11 aufgezeichnet. Zwischenzeitlich wird überprüft (S4), ob ein Benutzer bereits an der Steuereinheit 3 einen Befehl zum Einschalten des Funkempfängers 2 eingegeben hat. Dies wird unmittelbar nach der Inbetriebnahme des Funkempfängers 2 im allgemeinen nicht der Fall sein, da der Benutzer einige Sekunden braucht, um nach dem Öffnen des Türschlosses 6 in dem Fahrzeug Platz zu nehmen und einen Schaltbefehl zum Starten der Ausgabe eines vom Funkempfänger 2 gelieferten Ausgangssignals durch die Wiedergabeeinheit 4 an der Steuereinheit 3 einzugeben. Der Funkempfänger 2 geht daher zunächst über zu Schritt S5, in dem geprüft wird, ob im Frequenzband des Funkempfängers noch Frequenzen übrig sind, die nicht untersucht worden sind. Wenn ja, so wählt der Empfänger eine dieser Frequenzen und kehrt zu Schritt S3 zurück. Wenn nein, ist die Durchmusterung des Frequenzbandes beendet, und ein vollständiger Satz von Senderinformationen ist im Speicher 11 gespeichert, der es dem Funkempfänger 2 ermöglicht, jederzeit zu einer von einem Benutzer vorgegebenen Empfangsfrequenz oder einem vorgegebenen Sender die optimale Empfangsfrequenz auszuwählen.

Wenn in Schritt S4 oder während des Wartens S7 festgestellt wird, dass der Benutzer einen Schaltbefehl eingegeben hat, geht der Funkempfänger in den Arbeitsbetriebszustand S8 über, in dem er ein Ausgabesignal an die Wiedergabeeinheit 4 liefert.

Zu einem Zeitpunkt, der im allgemeinen nach dem Durchmustern des Frequenzbandes durch den Funkempfänger liegt, überprüft die Steuereinheit 3 die vom zweiten Sensor 9 erfasste Stellung des Zündschlosses 8. Wenn dieser anzeigt, dass der Motor angelassen worden ist oder dass zumindest der Zündschlüssel steckt und ein Stück weit gedreht worden ist, so bleibt der Funkempfänger 2 in Betrieb; andernfalls wird angenommen, dass der Funkempfänger nicht benötigt werden wird, und die Steuereinheit 3 nimmt ihn durch Unterbrechen seiner Stromversorgung außer Betrieb, wodurch auch die im Speicher 11 gesammelten Daten wieder verloren gehen. Durch diese Maßnahme wird sichergestellt, dass wenn das Fahrzeug längere Zeit mit unverschlossener Tür abgestellt ist, der Funkempfänger 2 nicht ständig überflüssigerweise Strom verbraucht und die Fahrzeugbatterie entleert.

Wenn die Prüfung des Schritts S6 ergibt, dass der Motor angelassen worden ist bzw. der Zündschlüssel gedreht worden ist, so bleibt der Funkempfänger 2 in Betrieb und geht in einen Wartezustand S7 über. Wenn der Benutzer keinen Befehl zum Einschalten des Funkempfängers 2 in die Steuereinheit 3 eingibt, kehrt die Verarbeitung nach einer vorgegebenen Zeitspanne von z.B. 15 min. zum Schritt S3 zurück, und die Durchmusterung des Frequenzbandes wird wiederholt. Auf diese Weise werden die Senderdaten im Speicher 11 aktuell gehalten, wenn das Fahrzeug sich bewegt, auch wenn der Benutzer nicht Radio hört. So bald der Benutzer einen Befehl zum Einschalten des Funkempfängers 2 gibt, wechselt der Funkempfänger 2 in den sogenannten Arbeitsbetriebszustand, in dem er ein aus einem bei der eingestellten Empfangsfrequenz empfangenen Funksignal gewonnenes Ausgangssignal über die Ringleitung 1 an die Wiedergabeeinheit 4 liefert.

Auch nachdem der Funkempfänger 2 in den Arbeitsbetriebszustand übergegangen ist, wechselt er noch von Zeit zu Zeit jeweils für kurze Zeitspannen in den Bereitschaftsbetriebszustand, um jeweils für einzelne von der eingestellten Empfangsfrequenz verschiedene Frequenzen dort eventuell empfangbare Sender zu identifizieren und die Empfangsfeldstärke zu erfassen und aufzuzeichnen. Da dies der herkömmlichen Betriebsweise eines Autobest-Empfängers entspricht, ist eine eingehende Beschreibung dieses Verhaltens hier nicht erforderlich.

Eine Vielzahl von Abwandlungen des oben beschriebenen Verfahrens ist möglich. So ist das Öffnen der Tür lediglich eines aus einer Vielzahl von an einem Fahrzeug erfassbaren Ereignissen, die eine Durchmusterung des Frequenzbereichs und das Sammeln von Senderinformation in Gang setzen können. Denkbar wäre z.B. auch, anstelle des Öffnens der Tür das Einstecken oder Drehen des Zündschlüssels zu erfassen. Auch in diesem Fall steht zwischen dem erfassten Ereignis und dem Eingeben eines Einschaltbefehls durch einen Benutzer meist noch eine kurze Zeitspanne zur Verfügung, in der zumindest ein Teil des Frequenzbereichs durchmustert werden kann.

Denkbar ist auch, den oben beschriebenen Schritt S4 nicht bei laufender Durchmusterung des Frequenzbereichs durchzuführen, sondern erst wenn diese abgeschlossen ist, d.h. zwischen den Schritten S5 und S6 in Fig. 2. Dies würde dazu führen, dass wenn ein Benutzer den Befehl zum Einschalten des Empfängers gibt, bevor dieser die Durchmusterung abgeschlossen hat, der Befehl so lange ignoriert wird und die Wiedergabeeinheit 4 stumm bleibt, bis die Durchmusterung abgeschlossen ist.

Wenn der Benutzer einen Befehl zum Ausschalten des Funkempfängers 2 in die Steuereinheit 3 eingibt, so führt dies nicht dazu, dass die Steuereinheit 3 die Stromversorgung des Funkempfängers 2 insgesamt unterbricht, sondern sie versetzt lediglich den Funkempfänger 2 zurück in den Bereitschaftsbetriebszustand.

Das gleiche geschieht, wenn die Ausgabeeinheit 4 ein Signal nicht von dem Funkempfänger 2, sondern von dem CD-Abspielgerät 10 oder einer anderen nicht dargestellten geeigneten Quelle empfängt.

## Patentansprüche

1. Anordnung für ein einen Motor aufweisendes Kraftfahrzeug
mit einem Empfänger (2) für Funksignale, der auf eine Mehrzahl unterschiedlicher Empfangsfrequenzen abstimmbar ist und eingerichtet ist, in einem Arbeitsbetriebszustand ein aus einem bei einer eingestellten Frequenz empfangenen Funksignal gewonnenes Signal an eine Wiedergabeeinheit auszugeben und in einem Bereitschaftsbetriebszustand Informationen wenigstens über die Identität eines bei einer gegebenen Frequenz empfangbaren Senders zu erfassen und in einem Speicher aufzuzeichnen, wobei
der Empfänger (2) eingerichtet ist, bei Inbetriebnahme zunächst im Bereitschaftsbetriebszustand (S2-S7) Information über eine Mehrzahl von Sendern zu erfassen und aufzuzeichnen (S3), bevor er in den Arbeitsbetriebszustand (S8) wechselt,
die Steuereinheit (3) an wenigstens einen Sensor (7) gekoppelt ist und eingerichtet ist, den Empfänger je nach Erfassungsergebnis des wenigstens einen Sensors (7) in und/oder außer Betrieb zu nehmen, und
einer der Sensoren ein Sensor (7) zum Erfassen der Annäherung eines Benutzers ist, und die Steuereinheit den Empfänger automatisch in Betrieb nimmt, wenn die Annäherung eines Benutzers erfasst wird, **dadurch gekennzeichnet,**
**dass** die Steuereinheit (3) zudem einen Sensor (9) zum Erfassen des Einschaltens des Motors des Kraftfahrzeugs umfasst und dass die Steuereinheit (3) den Empfänger (2) außer Betrieb nimmt, wenn in einer vorgegebenen Zeitspanne nach dem Erfassen der Annäherung der zusätzliche Sensor (9) anzeigt, dass der Motor des Fahrzeugs nicht eingeschaltet ist.

2. Anordnung nach Anspruch 1, **dadurch gekennzeichnet, dass** der Empfänger über eine Einrichtung zum Empfangen eines Schaltbefehls von einem Benutzer verfügt und bei Empfang des Schaltbefehls vom Bereitschaftsbetriebszustand (S2-S7) in den Arbeitsbetriebszustand (S8) wechselt.

3. Anordnung nach Anspruch 1 oder 2, **dadurch gekennzeichnet, dass** der Sensor (7) zum Erfassen der Annäherung eines Benutzers an den Zustand eines Türschlosses (6) des Kraftfahrzeugs gekoppelt ist und die Annäherung eines Benutzers am Öffnen des Türschlosses (6) erfasst.

4. Anordnung nach einem der Ansprüche 1 bis 3, **gekennzeichnet durch** eine Wiedergabeeinheit (4) zum wahlweisen Ausgeben eines Ausgangssignals des Empfängers (2) oder eines Ausgangssignals einer anderen Quelle (10) als akustisches Signal wobei der Empfänger (2) sich dauerhaft im Bereitschaftsbetriebszustand befindet, wenn die Wiedergabeeinheit (4) ein Ausgangssignal einer anderen Quelle (10) empfängt.

5. Anordnung nach einem der Ansprüche 1 bis 4, **dadurch gekennzeichnet, dass** die Steuereinheit (3) und der Empfänger (2) über ein Netzwerk (1) verbunden sind, dessen Inbetriebnahme eine Initialisierungszeitspanne erfordert, und dass die Inbetriebnahme des Empfängers an die des Netzwerks gekoppelt ist.

## Claims

1. A system for a motor vehicle having a motor including a receiver (2) for radio signals, which may be tuned to a plurality of different receiving frequencies and is arranged, in a working state, to supply to a reproduction unit a signal obtained from a radio signal received at a set frequency and, in a operational readiness state, to determine information relating to at least the identity of a transmitter which may be received at a pre-determined frequency and to record it in a store, wherein the receiver (2) is arranged, when put into operation, firstly, in the operational readiness state (S2-S7), to determine information relating to a plurality of transmitters and to record it before it changes into the operational state (S8), the control unit (3) being coupled to at least one sensor (7) and is arranged to switch the receiver on and/or off, depending on the result of the determination by the at least one sensor (7), and one of the sensors is a sensor (7) for detecting the approach of a user and the control unit automatically switches the receiver on when the approach of a user is detected, **characterised in that** the control unit (3) additionally includes a sensor (9) for detecting the switching on of the motor of the motor vehicle and that the control unit (3) switches the receiver (2) off when the additional sensor (9) indicates, within a pre-determined time period after the detection of the approach, that the motor of the motor vehicle has not been switched on.

2. A system as claimed in claim 1, **characterised in that** the receiver has a device for receiving a switching command from the user and, on receipt of the switching command, switches from the operational readiness state (S2-S7) into the operational state (S8).

3. A system as claimed in claim 1 or 2, **characterised in that** the sensor (7) for detecting the approach of a user is coupled to the condition of a door lock (6) of the motor vehicle and detects the approach of a user by the opening of the door lock (6).

4. A system as claimed in one of claims 1 - 3, **characterised by** a reproduction unit (4) for selectively supplying an output signal from the receiver (2) or an output signal from another source (10) in the form of an acoustic signal, whereby the receiver (2) is permanently in the operational readiness state when the reproduction unit (4) receives an output signal from another source (10).

5. A system as claimed in one of claims 1 - 4, **characterised in that** the control unit (3) and the receiver (2) are connected via a network (1), the switching on of which requires a period of time for initialisation and that the switching on of the receiver is coupled to that of the network.

## Revendications

1. Dispositif pour un véhicule comportant un moteur avec un récepteur (2) pour des signaux radio qui peut être accordé sur une pluralité de fréquences de réception différentes et qui est conçu pour envoyer à une unité de restitution, dans un état de fonctionnement, un signal obtenu à partir d'un signal radio reçu à une fréquence réglée et pour détecter, dans un état d'attente, des informations au moins sur l'identité d'un émetteur qui peut être reçu à une fréquence donnée et pour les enregistrer dans une mémoire, dans lequel
le récepteur (2) est conçu pour détecter, à la mise en service, d'abord à l'état d'attente (S2-S7) des informations sur une pluralité d'émetteurs et pour les enregistrer (S3) avant de passer à l'état de fonctionnement (S8),
l'unité de commande (3) est couplée à au moins un capteur (7) et est conçue pour mettre en service et/ou hors service le récepteur en fonction du résultat de la détection du au moins un capteur (7), et
l'un des capteurs est un capteur (7) pour la détection de l'approche d'un utilisateur et l'unité de commande met le récepteur automatiquement en service lorsque l'approche d'un utilisateur est détectée, **caractérisé en ce que**
l'unité de commande (3) comprend, en outre, un capteur (9) pour la détection du démarrage du moteur du véhicule et **en ce que** l'unité de commande (3) met le récepteur (2) hors service lorsque, dans un laps de temps prédéterminé après la détection de l'approche, le capteur supplémentaire (9) indique que le moteur du véhicule n'a pas été démarré.

2. Dispositif selon la revendication 1, **caractérisé en ce que** le récepteur est équipé d'un dispositif pour la réception d'une commande de commutation d'un utilisateur et il passe de l'état d'attente (S2-S7) à l'état de fonctionnement (S8) à la réception de la commande de commutation.

3. Dispositif selon la revendication 1 ou 2, **caractérisé en ce que** le capteur (7) pour la détection de l'approche d'un utilisateur est couplé à l'état d'une serrure de porte (6) du véhicule et il détecte l'approche d'un utilisateur lors de l'ouverture de la serrure de porte (6).

4. Dispositif selon l'une quelconque des revendications 1 à 3, **caractérisé par** une unité de restitution (4) pour l'émission sélective d'un signal de sortie de l'émetteur (2) ou d'un signal de sortie d'une autre source (10) sous forme de signal acoustique, le récepteur (2) se trouvant en permanence à l'état d'attente lorsque l'unité de restitution (4) reçoit un signal de sortie d'une autre source (10).

5. Dispositif selon l'une quelconque des revendications 1 à 4, **caractérisé en ce que** l'unité de commande (3) et le récepteur (2) sont reliés par l'intermédiaire d'un réseau (1) dont la mise en service nécessite une durée d'initialisation et **en ce que** la mise en service du récepteur est couplée à celle du réseau.
